(19) Europäisches Patentamt
European Patent Office
Office européen des brevets

(11) Publication number: **0 055 619 B1**

(12) # EUROPEAN PATENT SPECIFICATION

(45) Date of publication of patent specification: **29.05.85**

(51) Int. Cl.[4]: **C 30 B 15/30**, C 30 B 29/06

(21) Application number: **81306131.4**

(22) Date of filing: **24.12.81**

(54) **Method for regulating concentration and distribution of oxygen in Czochralski grown silicon.**

(30) Priority: **29.12.80 US 220924**

(43) Date of publication of application: **07.07.82 Bulletin 82/27**

(45) Publication of the grant of the patent: **29.05.85 Bulletin 85/22**

(84) Designated Contracting States: **DE FR GB IT NL**

(56) References cited:
**EP-A-0 042 901**
**FR-A-2 328 509**
**FR-A-2 413 124**

(73) Proprietor: **MONSANTO COMPANY**
**Patent Department 800 North Lindbergh Boulevard**
**St. Louis, Missouri 63166 (US)**

(72) Inventor: **Frederick, Roger Allen**
**12644 Northwinds**
**St. Louis Missouri 63141 (US)**
Inventor: **Moody, Jerry Wofford**
**3317 West Adams**
**St. Charles Missouri 63301 (US)**

(74) Representative: **Lunt, John Cooper et al**
**Monsanto Europe S.A. Patent Department**
**Avenue de Tervuren 270-272 Letter Box No 1**
**B-1150 Brussels (BE)**

**EP 0 055 619 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

Background of the Invention

This invention relates to a method for regulating concentration and distribution of oxygen in Czochralski drawn silicon crystal rods through variation of both the magnitude and relative sense of direction of seed and crucible rotation rates. In another aspect the invention relates to a method for achieving uniform axial and radial distribution of oxygen in Czochralski grown silicon rods through increasing crucible rotation rate to pre-selected values as a function of crystal rod growth and melt consumption. In yet another aspect the invention relates to a method for introducing various levels of oxygen into the Czochralski grown silicon rod through choice of initial rotation magnitude and direction of the seed and crucible.

The production of single crystals from materials such as silicon plays an important role in semiconductor technologies. A suitable method for growing the silicon crystals is known as the Czochralski technique in which a seed crystal, which has the desired crystal orientation, is introduced to a melt of silicon materials. The silicon melt can also contain certain dopants which are introduced for the purpose of modifying the electrical characteristics of the silicon as is known in the art. The melt is contained in a silica crucible or vessel which is heated so that the silicon melt is at, or slightly above, its melting point. The seed crystal is slowly withdrawn from the melt, in an inert atmosphere such as argon, and the silicon solidifies on the seed to produce the growth of a crystal rod. Generally, the Czochralski technique is utilized for producing single silicon crystal which is utilized by the electronics industry. A cylindrical crystal is produced by rotating the crystal as it is drawn. The crucible is conventionally rotated in the opposite direction for the purposes of assuring thermal symmetry in the growth environment. The withdrawing rate and power to the heating means is first adjusted to cause a neck down of the crystal. This eliminates dislocations caused by the thermal shock which occurs when the seed crystal initially contacts the melt. The withdrawing rate and the power is then adjusted to cause the diameter of the crystal to increase in a cone shaped manner until the desired crystal diameter is reached. The withdrawal rate and heating are then adjusted so as to maintain constant diameter until the process approaches an ending where again the rate and heating are increased so that the diameter decreases to form a cone portion at the end of the Czochralski rod.

In general commercial methods using the Czochralski techniques are limited to the amount of melt present in the crucible as to the size and volume of the drawn silicon crystal.

At the melt temperature of silicon (about 1,400°C), the surface of the silica crucible which is in contact with the melt dissolves and forms silicon monoxide, SiO, which enters the melt and evaporates from the surface of the melt. The SiO is the predominant source of oxygen which enters the melt and, consequently the drawn crystal.

Silicon crystals grown from melts contained in silica generally have a concentration of oxygen of about 10 to 50 parts per million atomic (ppma) as measured by ASTM standard F-121. The oxygen from the silica crucible reacts with molten silicon forming SiO which dissolves in the melt. A portion of the dissolved SiO is incorporated in the growing crystal. The oxygen concentration in silicon crystals grown under Czochralski conditions prevalent in the industry today is not uniform but varies along the length of the crystal, for example, being higher at the seed end than in the middle and/or bottom or tail end of the crystal. The difference in the maximum and minimum oxygen concentrations within one crystalline silicon rod is generally 10 ppma or greater which constitutes an oxygen concentration difference of 30% or greater.

Although oxygen in Czochralski grown silicon has long been regarded as a more or less undesirable impurity, until recently its presence has not been of great concern because the oxygen can be rendered electrically inactive by proper heat-treatment. However, oxygen does tend to precipitate from solid solution or react with other impurities or lattice defects to form microdefects when the crystal is subjected to the diffusion and heat-treatment processes typical of modern silicon technology. Such microdefects can be either benefical or deleterious to solid-state electronic device yields depending on the concentration of oxygen and the processing steps to which the crystal (or wafer) is subjected. Thus, to increase device yields, it is becoming ever more desirable and necessary to grow silicon crystals having a specified oxygen content and distribution.

Methods for enhancing the concentration of oxygen in Czochralski grown silicon crystals have been described in the patent and other literature wherein, for example, during the Czochralski process the crucible rotation is stopped and started several times during the process to provide fluid shearing at the melt-crucible interface. In another art taught method, oxygen content of Czochralski produced silicon is enhanced by changing surface characteristics of the portion of the silica vessel which is in contact with the melt so as to provide an increased oxygen concentration in the melt during the crystal drawing process. In yet another approach, lower oxygen concentrations are attempted through lower initial crystal rotation rates followed by relatively slow acceleration of the crystal rotation rate during the Czochralski pull.

All of the above methods have been evaluated and found to be lacking in certain respects. The range of oxygen concentrations obtainable appears to be limited to relatively high oxygen concentrations and/or the methods fail to produce the desired uniform axial distribution of the oxygen concentration. The present invention allows for control of oxygen in Czochralski produced silicon rods over a wide range of concentrations, for example from about 15 ppma to about 40 ppma or greater, and results in significantly improved uniform axial distribution of the oxygen.

Summary of the Invention

In accordance with this invention, a method is provided for regulating oxygen content and distribution of the oxygen content in silicon crystal rod made by the Czochralski method using a seed crystal and a melt of silicon contained in a silica crucible. The seed crystal is rotated in one direction and the silica crucible in the opposite direction. The regulating method according to the invention is characterised in that the initial rate of rotation of the seed crystal is greater than that of the crucible and the rate of rotation of the crucible is progressively increased as the rod is grown and the level of the melt in the crucible diminishes.

In one embodiment of the invention, the rate of rotation of the crucible is progressively increased while holding the rate of rotation of the seed crystal constant at a higher value than the maximum reached by the crucible.

In another embodiment of the invention, the rate of rotation of the seed crystal is also increased as the crucible melt level diminishes, and this may be done so that the rates of rotation of the seed crystal are greater than the rates of rotation of the crucible.

Typically, the seed crystal is rotated at from about 5 to about 40 rpm and the rate of rotation of the crucible is increased within the range from about 1 to about 40 rpm. The method can be regulated to produce a single crystal silicon rod having an axial and radial concentration gradient of oxygen content i.e. a difference between the highest and the lowest oxygen concentration along the axis of the rod and along a radius of the rod respectively, of less than about 10 ppma, through up to about 98% of the rod length.

Brief Description of the Drawings

The seven (7) drawings present figures illustrating various control of the Czochralski methods as well as the effects of variations of both magnitude and relative sense of direction of seed and crucible rotation rates wherein oxygen concentration ppma is plotted against the percent crystal length or percent frozen of the Czochralski rod. The drawings present results which are in accordance with the invention as well as art taught control methods for comparative purposes.

Detailed Description

The foregoing and other objects, features and advantages of the invention will be apparent from the following more particular description of the preferred embodiments of the invention.

As described above, a commonly used method for the growth of single crystals of semi-conductor materials such as silicon is the well known Czochralski method in which a charge of very pure silicon, from which the single crystal is to be drawn is placed in a silica crucible. Development and research investigations of the Czochralski methods and products produced by the Czochralski method have indicated that the content and distribution of oxygen in Czochralski silicon crystals depends on the crucible and crystal rotation rates as well as other process parameters such as growth rate, crystal diameter, crucible diameter, melt depth and the like.

The dependence of oxygen concentration on rotation rates is complicated and was found to be a function of both the magnitude and the relative sense of direction of the rotation rates. In general, for counter-rotations with the seed rotating faster than the crucible, oxygen concentration increases with both crystal and crucible rotation rates and is especially sensitive to the crucible rotation. The oxygen concentration is reduced for isorotations or for counter-rotations with the crucible rotating faster than the crystal. These effects are illustrated by the distribution curves shown in Figure 1. In Figure 1, crystal numbers 1 through 4 have crystal and crucible rotation rates in rpm's identified by CW (clockwise) and CCW (counterclockwise) rotation. According to Figure 1, crystal number 1 which is not in accordance with the invention illustrates a high head concentration of about 32 ppma while illustrating poor oxygen concentration gradient to tail oxygen concentration of about 14 ppma. The Czochralski process for producing crystal number 1 illustrates a crystal rotation rate of less than the crucible rotation rate and rotation in the same direction, such teachings being contrary to the processes according to the invention. None of the crystals of Figure 1, for example, number 4 which is somewhat attuned to the methods used in commercial processes, provide uniform oxygen concentration distribution. The graphs of Figure 1 do illustrate that the higher the rotation rates especially in counter-rotation modes, the higher the oxygen concentration.

It has been found that Czochralski produced silicon crystals contain oxygen as an impurity in amounts of from about 50 ppma at the head end to about 10 ppma at the tail end. The oxygen content results from the contact of the hot melt on the silica surface of the crucible which forms silicon monoxide and introduces oxygen into the melt. It is believed that initially the oxygen content of the melt is at about saturation. The concentration of oxygen apparently decreases during the crystal pulling process due to a lower dissolution rate of the crucible surface. This lower dissolution rate is attributed primarily to the lower silicon to silica contact area as the molten silicon is withdrawn from the crucible. It is desirable that the seed to tail oxygen concentration be kept uniform throughout the silicon rod in the approximate oxygen concentration range of from about 15 ppma to about 40 ppma.

The concentration and distribution of oxygen in Czochralski silicon crystals depends on the crystal diameter and charge size as well as crucible size, and on the seed crystal and crucible rotation rates and direction. The figures include comparative method graphs which illustrate present technology from 50 mm. to 100 mm. diameter crystals and illustrate the point that for a particular system having constant conditions other than rotation rates, the oxygen concentration and distribution will depend on seed crystal and crucible rotation rates and direction. In most cases the figures illustrate data based on averages of more than one run. In general, oxygen distributions are found to be reproducible to plus or minus less than 2 ppma oxygen for a particular set of growth parameters.

The comparisons as illustrated in the figures provide 50 to 100 mm. diameter crystals drawn from different charge sizes with some of the programmed crucible rotation rates increased manually rather than automatically; however, these comparative graphs are maintained to be adequate for demonstrating the advantages achieved through the present inventive process as compared to prior art methods. It is reasonable to expect that significant improvements in uniform distribution and control can be achieved through refinements of the invention conditions and rotation magnitude directions.

The method according to the invention was partially deduced from curves such as those shown in Figures 3, 5, 6, and 7, curves A and B of Figure 3 were the results of an early attempt to regulate oxygen concentration and axial distribution. When reviewing Figure 3 which is in accordance with the invention, programmed crucible rotation rate increase is illustrated as being very effective; however, the graphic representation is in no way intended to represent perfected use of the invention. The flexibility of utilizing the method according to the invention not only allows regulation of oxygen concentration, but regulation of the uniform distribution of the oxygen throughout the rod and such technology is considered to be applicable to future rod crystals of greater diameters.

In reviewing certain art taught methods of adjusting oxygen content in Czochralski grown crystal, the shearing force or action brought about by the sudden starting and stopping of a crucible rotation is stated to be a method for stripping a passivating layer of SiO from the surface of the crucible. Certainly, the inertia of the melt would provide such an action when the crucible is started or stopped. In the method according to the invention, the shearing action brought about by a gradual increase in the crucible rotation rate would be insignificant; therefore, the uniform distribution of oxygen resulting from the inventive method must be due to a different cause. It is believed that the gradual increase in the crucible rotation rate affects the diffusion layer in the liquid adjacent to the crucible in such a way as to allow more uniform dissolution of the crucible as the run progresses. In addition, it is possible that the melt flow patterns or convection are affected in a way which is also beneficial. Stripping a passivating layer from the crucible wall is fundamentally different from altering a diffusion layer in the melt.

With various experimental data and art-known methods available which were lacking in many respects through pre-determined oxygen distribution and concentration regulation, the method according to the invention was conceived wherein uniform oxygen distribution and concentration regulation was achieved in crystals grown by the Czochralski method by properly manipulating the rotation rates of crystal and crucible as the crystal is grown. Since the uniform axial and radial distribution of oxygen is most desired, most of the effort was directed toward enhancing uniformity over the length of the crystal. This was accomplished by increasing the crucible rotation rate according to a pre-selected schedule as the crystal was grown. Some typical results are shown in Figure 3, curve A wherein the results were obtained from a ⟨100⟩, 60 millimeter diameter crystal grown from a 255 mm. diameter crucible. In this experiment, the crucible rotation rate was increased, manually, from 15 to 25 RPM during the rod growth. The crucible rotation rate was increased 1 RPM for each 127 mm. of crystal growth. The crystal was rotated at 27 RPM in the opposite direction to that of the crucible rotation. The average oxygen concentration is about 34 ppma and the improved axial uniformity is obvious when curve A is compared with those of, for example, Figures 1, 2 and 4.

Curve B of Figure 3 shows the results obtained on a ⟨100⟩, 100 millimeter diameter crystal grown from a 330 mm. diameter crucible. In this experiment, the crucible rotation rate was increased automatically from 15 to 25 RPM as the crystal was grown. The crystal was rotated at 25 RPM in the opposite direction to that of the crucible and again the improved axial distribution of oxygen is readily apparent.

The information illustrated in Figures 1—7 is presented herein to show various results from a variety of art-known methods as compared to the method according to the invention; however, the presentation according to the invention is intended in no way to limit the scope of the invention, but rather to illustrate the advantages achievable by the invention. It should be obvious from the presentations of the figures that a silicon crystal with a pre-determined oxygen concentration can be grown by selecting initial crystal and crucible rotation rates and then changing either or both rotation rates at a pre-selected schedule as the crystal is grown.

The drawings, Figures 1 and 2, present method results outside the scope of the present invention for producing Czochralski silicon. In these methods the oxygen distribution on an axial basis can be unacceptable for electronics industry needs. In addition, the curves of comparative Figures 1 and 2 do not concern themselves with radial oxygen distribution which obviously constitutes an important factor in overall oxygen distribution gradient of modern silicon use demands. While some of the comparative curves of Figures 1 and 2 appear to be reasonably flat, the axial oxygen distribution curves are somewhat misleading since much of the rods produced by these art-taught methods would fall outside acceptable oxygen gradient classification. The method according to the invention, on the other hand, provides Czochralski grown silicon rods which can be utilized substantially throughout the length of the rod since the oxygen gradient is evenly controlled. For example, prior art methods produce Czochralski silicon rods having unacceptable, broad oxygen gradients when comparing the head and tail portions of the rod. Without utilizing the method according to the invention, prior produced Czochralski rods would have high oxygen content at the head of the rod, close to saturation, and low oxygen concentration at the tail or at the end of the rod when the crucible melt level is reduced to a minimum.

The present invention is also concerned in controlling the radial concentration and controlling axial concentration of oxygen throughout the entire length of the Czochralski grown silicon rod. As can be seen from the comparative curves of Figure 4 which are not in accordance with the invention, substantial oxygen gradient exists between the axial curve and the radial curve as well as head to tail phenomena common to prior art systems. In Figures 5 and 6 the method according to the invention is utilized in a very positive manner for controlling both the axial and radial oxygen distribution in a Czochralski grown crystal. The oxygen distribution as indicated in Figures 5 and 6 are in accordance with the invention with the exception that the crucible rotation rate was held constant after about 80 to 85% crystal length growth. In both cases, the cessation of increasing the crucible rotation rate as the crucible melt level diminishes, resulted in significant lowering of the oxygen content at the tail of the crystal rod. Not only does the data presented in Figures 5 and 6 illustrate the advantages according to the invention, but also illustrates the disadvantages that occur when the method according to the invention is altered. The oxygen distribution of Figure 7 which is in accordance with the invention and is more uniform in the tail portion of the rod as compared with the rods of Figures 5 and 6 simply because the process according to the invention, i.e. increasing crucible rotation rate, was prolonged up to essentially full crystal length growth.

Figures 5, 6 and 7 illustrate a preferred embodiment of the invention wherein the method is regulated such that over from 80 percent to 95 percent of the crystal length, the difference between the highest and the lowest oxygen concentration along the axis is less than about 8 ppma; and the radial distribution is such that the difference between the oxygen concentration at the edge of the rod and at the center of the rod is less than 8 ppma. More preferably, the said difference in the axial concentration of oxygen is less than about 5 ppma, and the said difference in the radial concentration is less than about 4 ppma.

## Claims

1. A method for the production of a silicon crystal rod by the Czochralski method using a seed crystal rotating in one direction and a silicon melt contained in a silica crucible rotating in the opposite direction, whereby the content and distribution of oxygen in the rod is regulated, characterised in that the initial rate of rotation of the seed crystal is greater than that of the crucible and the rate of rotation of the crucible is progressively increased as the rod is grown and the level of the melt in the crucible diminishes.

2. A method according to Claim 1 wherein the radial and the axial oxygen concentration gradient in the rod are each less than about 8 ppma.

3. A method according to either of Claims 1 and 2 wherein the oxygen content is regulated within the limits of from about 15 ppma to about 40 ppma through a function of initial melt crucible and crystal seed rod rotation rates.

4. A method according to any of Claims 1 to 3 wherein the seed crystal is rotated at from about 5 to about 40 rpm and the crucible rotation rate is increased within the range from about 1 to about 40 rpm.

5. A method according to any of Claims 1 to 4 wherein the axial distribution of oxygen content is regulated within a concentration gradient of less than about 5 ppma.

6. A method according to any of Claims 1 to 5 wherein the radial distribution of oxygen content is regulated within a concentration gradient of less than about 4 ppma.

7. A method according to any of Claims 1 to 6 wherein the seed crystal consists of single crystal silicon.

8. A method according to any of Claims 1 to 7 wherein the rate of rotation of the seed crystal is held constant at a rate greater than the maximum melt crucible rotation rate achieved.

9. A method according to any of Claims 1 to 7 wherein the rate of rotation of the seed crystal is increased as the crubible melt level diminishes.

10. A method according to any of Claims 1 to 9 which is regulated to produce a single crystal silicon rod having an axial and radial concentration gradient of oxygen content of less than about 10 ppma through up to about 98% of the rod length.

## Revendications

1. Procédé de fabrication d'une tige de cristal en silicium par le procédé Czochralski utilisant une rotation du cristal d'ensemencement dans une direction et une masse fondue de silicium contenue dans un creuset en silice tournant dans la direction opposée, ce qui a pour effet de réguler la teneur et la distribution d'oxygène dans la tige, caractérisé en ce que la vitesse initiale de rotation du cristal d'ensemencement est supérieure à celle du creuset et on augmente progressivement la vitesse de rotation du creuset pendant la croissance de la tige et la diminution du niveau de la masse fondue dans le creuset.

2. Procédé selon la revendication 1, où les gradients de concentration radiale et axiale d'oxygène dans la tige sont chacun inférieurs à environ 8 ppma.

3. Procédé selon l'une ou l'autre des revendications 1 et 2, où la teneur en oxygène est régulée à l'intérieur des limites allant d'environ 15 ppma à environ 40 ppma grâce aux vitesses de rotation initiale du creuset contenant la masse fondue et de la tige d'ensemencement de cristal.

4. Procédé selon l'une quelconque des revendications 1 à 3, où le cristal d'ensemencement est soumis à une rotation comprise entre environ 5 et environ 40 tours/minute et on augmente la vitesse de rotation du creuset dans une plage allant d'environ 1 à environ 40 tours/minute.

5. Procédé selon l'une quelconque des revendications 1 à 4, où l'on régule la distribution axiale de la teneur en oxygène à l'intérieur d'un gradient de concentration inférieur à environ 5 ppma.

6. Procédé selon l'une quelconque des revendications 1 à 5, où l'on régule la distribution radiale de la teneur en oxygène à l'intérieur d'un gradient de concentration inférieur à environ 4 ppma.

7. Procédé selon l'une quelconque des revendications 1 à 6, où le cristal d'ensemencement est constitué de silicium monocristallin.

8. Procédé selon l'une quelconque des revendications 1 à 7, où la vitesse de rotation du cristal d'ensemencement est maintenue constante à une valeur supérieure à la vitesse de rotation maximum obtenue du creuset de masse fondue.

9. Procédé selon l'une quelconque des revendications 1 à 7, où l'on augmente la vitesse de rotation du cristal d'ensemencement alors que le niveau de la masse fondue diminue dans le creuset.

10. Procédé selon l'une quelconque des revendications 1 à 9, qui est régulé de manière à produire une tige de silicium monocristallin ayant un gradient de concentration axiale et radiale de la teneur en oxygène inférieur à environ 10 ppma jusqu'à environ 98% de la longueur de la tige.

**Patentansprüche**

1. Verfahren zur Herstellung eines Siliciumkristallstabes nach dem Czochralski-Verfahren unter Verwendung eines in einer Richtung rotierenden Impfkristalls und einer in einem in entgegengesetzter Richtung rotierenden Siliciumdioxid-Tiegel enthaltenen Siliciumschmelze, wodurch der Gehalt und die Verteilung von Sauerstoff in dem Stab geregelt werden, dadurch gekennzeichnet, daß die anfängliche Rotationsgeschwindigkeit des Impfkristalls größer als diejenige des Tiegels ist und die Rotationsgeschwindigkeit des Tiegels zunehmend erhöht wird, wenn der Stab gezüchtet wird und das Niveau der Schmelze in dem Tiegel abnimmt.

2. Verfahren nach Anspruch 1, worin der radiale und der axiale Sauerstoffkonzentrationsgradient in dem Stab weniger als etwa 8 ppma betragen.

3. Verfahren nach einem der Ansprüche 1 und 2, worin der Sauerstoffgehalt innerhalb der Grenzen von etwa 15 ppma bis etwa 40 ppma durch eine Funktion der anfänglichen Schmelztiegel- und Impfkristallstab-Rotationsgeschwindigkeiten reguliert wird.

4. Verfahren nach einem der Ansprüche 1 bis 3, worin der Impfkristall mit etwa 5 bis etwa 40 Upm rotiert und die Tiegel-Rotationsgeschwindigkeit innerhalb des Bereiches von etwa 1 bis etwa 40 Upm erhöht wird.

5. Verfahren nach einem der Ansprüche 1 bis 4, worin die axiale Verteilung des Sauerstoffgehaltes innerhalb eines Konzentrationsgradienten von weniger als etwa 5 ppma geregelt wird.

6. Verfahren nach einem der Ansprüche 1 bis 5, worin die radiale Verteilung des Sauerstoffgehaltes innerhalb eines Konzentrationsgradienten von weniger als etwa 4 ppma geregelt wird.

7. Verfahren nach einem der Ansprüche 1 bis 6, worin der Impfkristall aus Silicium-Einkristall besteht.

8. Verfahren nach einem der Ansprüche 1 bis 7, worin die Rotationsgeschwindigkeit des Impfkristalls konstant bei einer größeren Geschwindigkeit als der maximal erreichten Rotationsgeschwindigkeit des Schmelztiegels gehalten wird.

9. Verfahren nach einem der Ansprüche 1 bis 7, worin die Rotationsgeschwindigkeit des Impfkristalls gesteigert wird, wenn das Niveau der Tiegelschmelze abnimmt.

10. Verfahren nach einem der Ansprüche 1 bis 9, welches so reguliert ist, um einen Silicium-Einkristallstab mit einem axialen und radialen Konzentrationsgradienten des Sauerstoffgehalts von weniger als etwa 10 ppma über bis zu etwa 98% der Stablänge herzustellen.

FIG. 1.

AXIAL DISTRIBUTION OF OXYGEN IN 60 MM DIAMETER CRYSTALS GROWN WITH CONSTANT ROTATION RATES

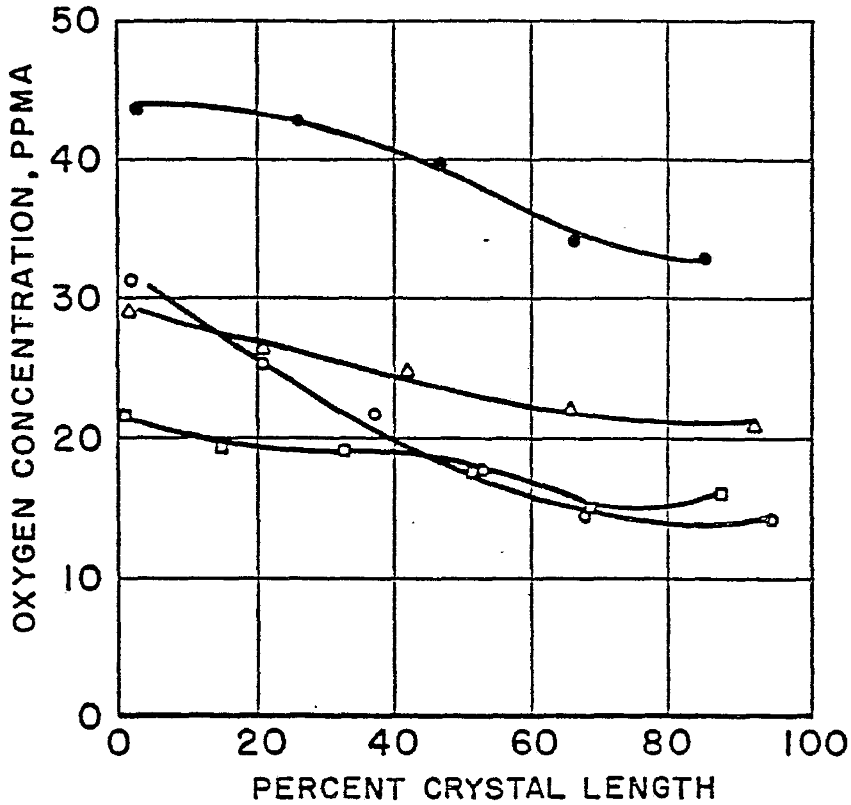


LEGEND

| CRYSTAL NUMBER | CRYSTAL ROTATION RATE (RPM) | CRUCIBLE ROTATION RATE (RPM) |
|---|---|---|
| ○ – 1 | 5 CCW | 9 CCW |
| □ – 2 | 5 CCW | 11 CW |
| △ – 3 | 20 CCW | 1 CW |
| ● – 4 | 25 CCW | 20 CW |

# FIG. 2.

AXIAL DISTRIBUTION OF OXYGEN IN 100 MM DIAMETER CRYSTALS GROWN WITH CONSTANT ROTATION RATES

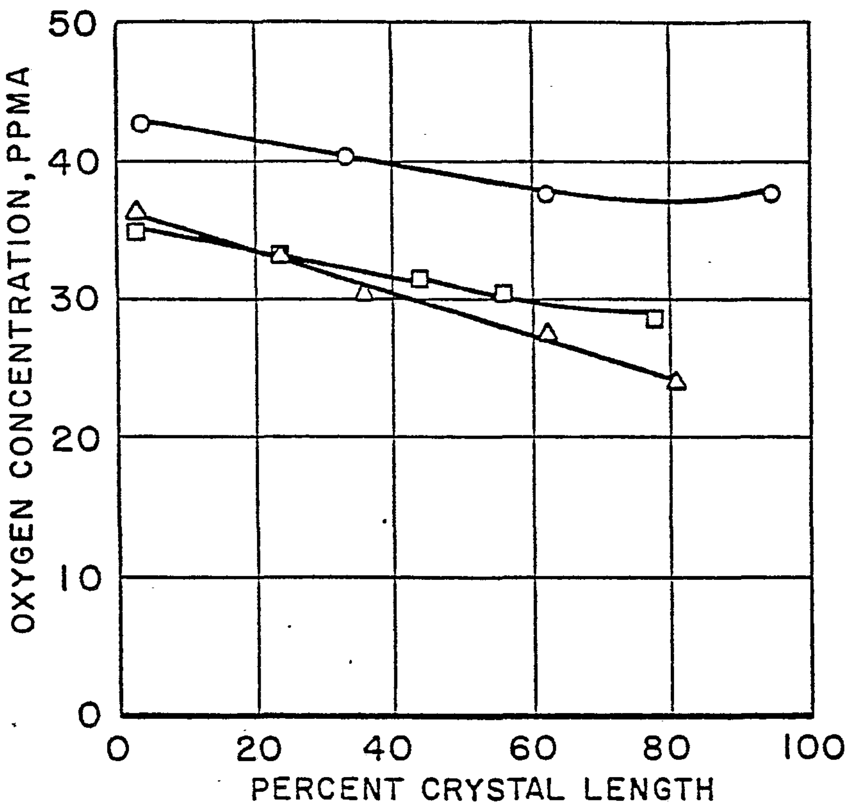


LEGEND

| CRYSTAL NUMBER | CRYSTAL ROTATION RATE (RPM) | CRUCIBLE ROTATION RATE (RPM) |
|---|---|---|
| ○ - 1 | 25 CW | 15 CCW |
| □ - 2 | 15 CW | 10 CCW |
| △ - 3 | 25 CW | 5 CCW |

FIG. 3.

OXYGEN DISTRIBUTION IN SILICON CRYSTALS GROWN WITH PROGRAMMED CRUCIBLE ROTATION RATE INCREASE

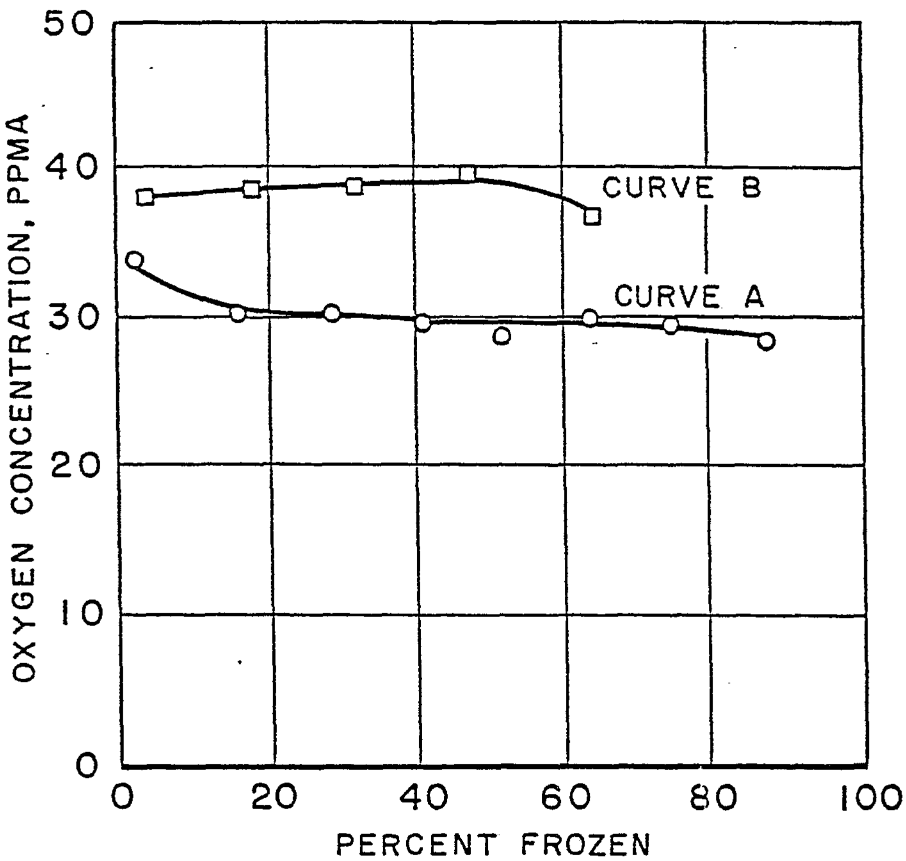

FIG. 4.

AXIAL AND RADIAL OXYGEN DISTRIBUTION IN A 80 MM DIAMETER CRYSTAL GROWN WITH CONSTANT ROTATION RATES

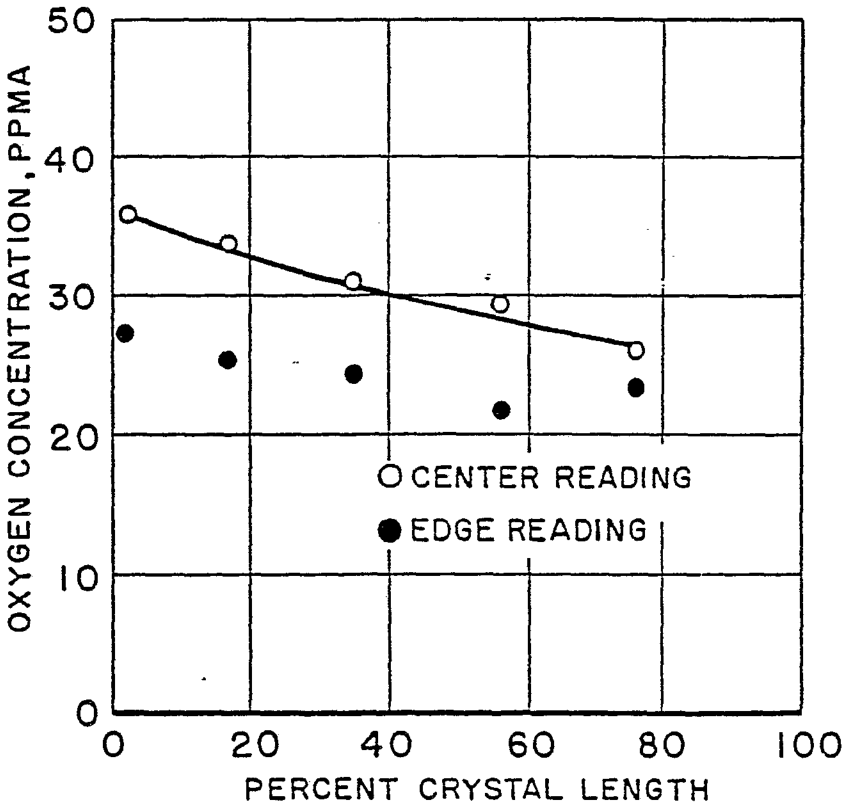


SEED ROTATION 15 RPM CW
CRUCIBLE ROTATION 10 RPM CCW

FIG. 5.

AXIAL AND RADIAL DISTRIBUTION OF OXYGEN IN A 80 MM DIAMETER CRYSTAL GROWN WITH PROGRAMMED CRUCIBLE ROTATION RATE INCREASE

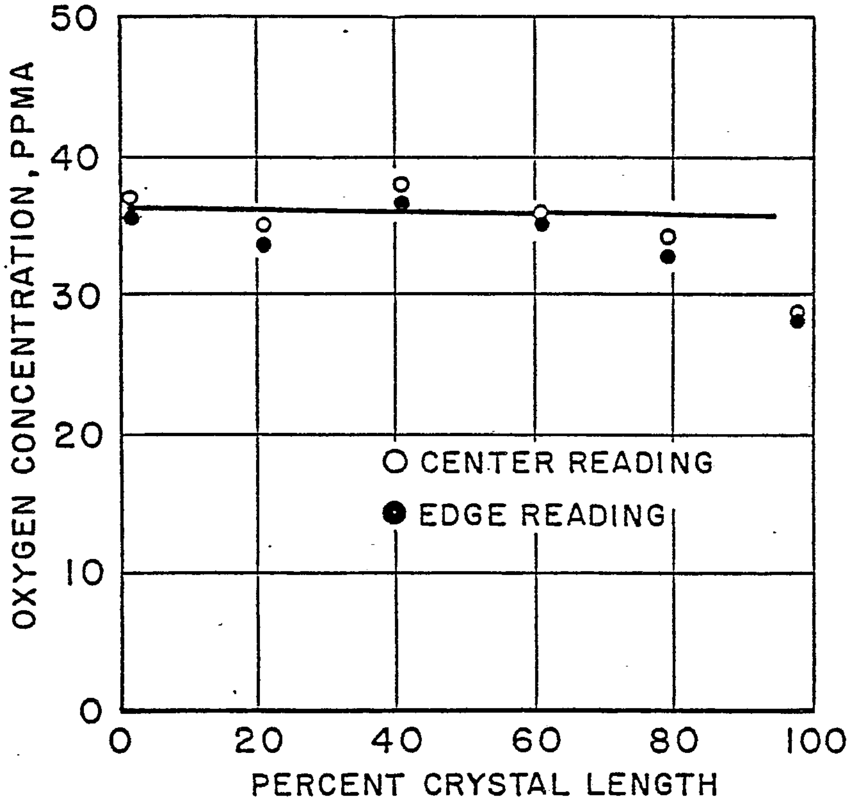


SEED ROTATION 35 RPM
CRUCIBLE ROTATION 13→25 RPM CCW

FIG. 6.

AXIAL AND RADIAL DISTRIBUTION OF OXYGEN IN A 100 MM DIAMETER CRYSTAL GROWN WITH PROGRAMMED CRUCIBLE ROTATION RATE INCREASE

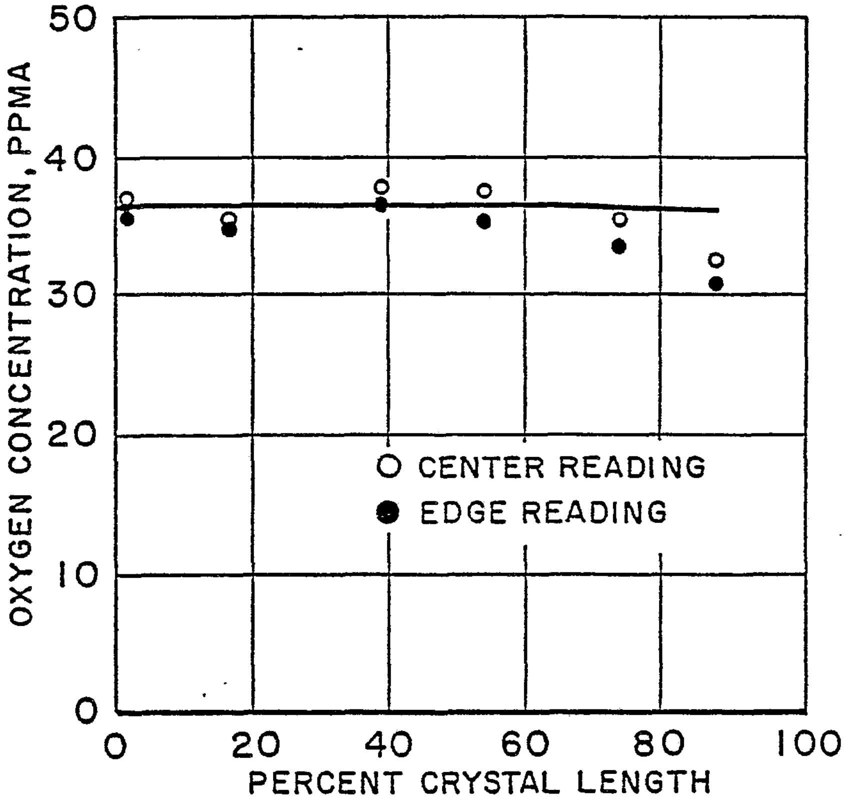


SEED ROTATION 28 RPM CW
CRUCIBLE ROTATION 10→25 RPM CCW

FIG. 7.

AXIAL AND RADIAL DISTRIBUTION OF OXYGEN IN A 80 MM DIAMETER CRYSTAL GROWN WITH PROGRAMMED CRUCIBLE ROTATION RATE INCREASE

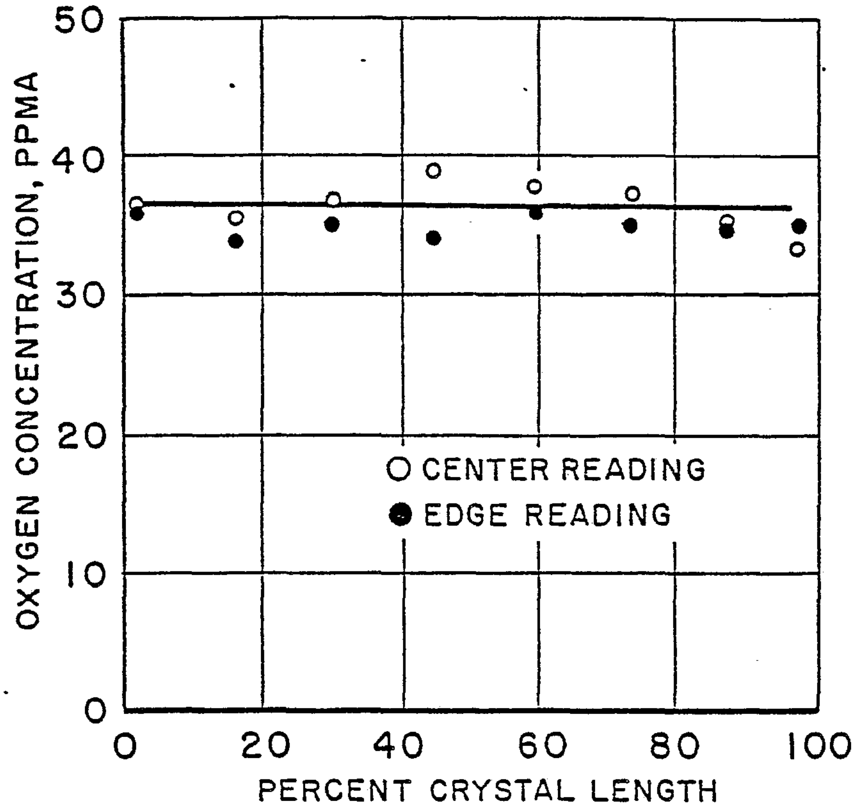


SEED ROTATION 28 RPM CW
CRUCIBLE ROTATION 12→25 RPM CCW